# EUROPÄISCHE PATENTSCHRIFT

(11) **EP 0 756 020 B1**
(45) Veröffentlichungstag und Bekanntmachung des Hinweises auf die Patenterteilung: **02.12.1998**
(21) Anmeldenummer: 96106161.1
(22) Anmeldetag: 19.04.1996
(51) Int. Cl.: C23C 14/04, C23C 14/56

(54) **Verfahren und Vorrichtung zur Herstellung von metallfreien Streifen bei der Metallbedampfung**
Method and device for the manufacture of metal-free sheets using a procedure of metal evaporation
Procédé et dispositif pour l'obtention de raies exemptes de métal lors de la métallisation par condensation de vapeurs

(30) Priorität: 28.07.1995 DE 19527604
(43) Veröffentlichungstag der Anmeldung: 29.01.1997
(73) Patentinhaber: Balzers und Leybold Deutschland Holding Aktiengesellschaft, 63450 Hanau (DE)
(72) Erfinder: Eller, Detlef, 63546 Hammersbach (DE); Achtner, Wolfgang, 63477 Maintal (DE); Klemm, Günter, 63667 Nidda (DE); Vogt, Thomas, 63538 Grosskrotzenburg (DE)

(56) Entgegenhaltungen:
- EP-A- 0 406 641
- EP-A- 0 494 340
- EP-A- 0 577 922
- EP-A- 0 652 302
- DE-B- 2 652 438
- DE-C- 3 224 234
- DE-C- 4 128 382

## Beschreibung

Die Erfindung betrifft ein Verfahren zur Herstellung von metallfreien Streifen bei der Metallbedampfung eines Isolierstoffbandes, das für den Einsatz in elektrischen Kondensatoren bestimmt ist, bei dem das Isolierstoffband im Bereich der herzustellenden metallfreien Streifen durch ein endloses, am Isolierstoffband anliegendes und mit gleicher Geschwindigkeit mit diesem mitlaufendes Abdeckband abgedeckt ist, das vor dem Einlaufen in die Bedampfungszone auf der dem Metallbedampfer zugewandten Seite mit Öl beschichtet ist und betrifft eine Vorrichtung zur Durchführung des Verfahrens.

Bekannt ist eine Vorrichtung der infragestehenden Art, bei der ein Abdeckband aus Papier oder Metall synchron und im Kontakt mit dem Isolierstoffband bewegt wird, um metallfreie Streifen auf dem im übrigen zu beschichtenden Isolierstoffband zu erzeugen (US 2,898,241).
Bekannt ist weiterhin ein Verfahren zur Herstellung metallfreier Streifen auf einem Isolierstoffband bei der Metallbedampfung (DE 32 24 234 C2), mit dem nicht scharfkantige Übergänge der metallbeläge zum metallfreien Streifen erzeugt werden.

Aufgabe der vorliegenden Erfindung ist es, die bekannten Verfahren und Vorrichtungen so zu verbessern, daß zum einen ein scharfkantiger Übergang vom Metallstreifen zur metallfreien Partie erzeugt wird. Außerdem soll sichergestellt werden, daß keine Verschmutzung der Wickeleinrichtung und des Folienbandes durch überschüssiges, vom Abdeckband abtropfendes oder abgestreiftes Öl erfolgen kann.

Diese Aufgabe wird erfindungsgemäß durch das Verfahren gemäß Anspruch 1 sowie die Vorrichtung gemäß Anspruch 2 gelöst, wobei das Abdeckband nach dem Durchlaufen durch die Bedampfungszone und nach dem Auseinanderführen des Abdeckbandes und des Isolierstoffbandes vom aufgedampften Öl durch Erhitzen des Abdeckbandes an einem in unmittelbarer Nachbarschaft des Abdeckbandes angeordneten Heizer befreit wird, wobei das vor dem Durchlauf des Bandabschnitts durch die Zone zur Metallbedampfung auf das Band aufgedampfte Öl nach dem Passieren der Bedampfungszone wieder verdampft und von der Vakuumpumpe abgesaugt wird.

Die Erfindung läßt die verschiedensten Ausführungsmöglichkeiten zu, eine davon ist in der anhängenden Zeichnung rein schematisch und im Schnitt dargestellt.

Die Vorrichtung zur Herstellung von metallfreien Streifen bei der Metallbedampfung eines Isolierstoffbandes 3 besteht im Wesentlichen aus einer Vakuumkammer 15, die mit Hilfe von Trennblechen 13, 14 in eine Verdampferkammer 12 und einen Wikkelraum 17 aufgeteilt ist, wobei die drehbar gelagerte Beschichtungswalze 16 so angeordnet ist, daß sie durch den von den Trennblechen gebildeten Spalt bis in die Verdampferkammer ragt. Über die Beschichtungswalze 16 ist das Isolierstoffband 3 geführt, das von der Vorratsrolle 10 über Hilfswalzen 18, 19 und die Beschichtungswalze 16 auf die Aufwickelrolle 9 geführt ist. Unterhalb der Beschichtungswalze 16 ist der Metallverdampfer 6 angeordnet, der von einem Verdampferkasten 20 umschlossen ist und mit einer Drahtzuführeinrichtung 21 zusammenwirkt. Der Verdampferkasten ist an seiner Oberseite mit einer Blende 22 versehen, die aus dem Bereich der Verdampferschiffchen verfahrbar ist und die die von einem Kragen 11 umschlossene Badampfungszone 5 nach unten zu begrenzt. Das Abdeckband 4 ist über Leitwalzen 23, 23',... und die Beschichtungswalze 16 geführt und als Endlosband ausgebildet.

Während des Beschichtungsvorgangs läuft das Isolierstoffband 3 von der Vorratsrolle 10 über die Beschichtungswalze 16 und die Hilfswalze 18 auf die Aufwickelrolle 9. Gleichzeitig und synchron mit dem Isloierstoffband 3 läuft das endlose Abdeckband 4 über die Beschichtungswalze 16, wobei das Abdeckband 4 mit Vorspannung auf dem Isolierstoffband 3 im Bereich der Bedampfungszone 5 fest anliegt. Von der Drahtzuführeinrichtung 21 wird der zu verdampfende Metalldraht 24 zum Metallbedampfer 6 geführt und hier verdampft, wobei der aufsteigende Metalldampf bei geöffneter Blende 22 (bzw. entfernter Blende) bis in die vom Kragen 11 umschlossene Bedampfungszone 5 aufsteigt und die vom Abdeckband 4 frei gelassenen Partien des Isolierstoffbandes bedampft. Das Abdeckband 4 wird vorher vom Öl-Verdampfer 8 an seiner dem Isolierstoffband 3 abgekehrten Seite mit Öl bedampft, so daß sich danach kein Metalldampf auf dem Abdeckband 4 niederschlagen kann. Das Abdeckband 4 läuft nach dem Passieren der Bedampfungszone 5 über den Heizer 7, der das auf dem Abdeckband niedergeschlagene Öl restlos verdampft, so daß das Band 4 anschließend vom Öl-Verdampfer mit einem neuen Öl-Film versehen werden kann. Auf diese Weise wird gewährleistet, daß das Abdeckband 4 scharfe Übergänge von den beschichteten zu den unbeschichteten Partien des Isolierstoffbandes 3 erzeugt. Das Entfernen des Ölfilms unmittelbar nach dem Passieren der Verdampfungszone 5 vom Abdeckband gewährleistet, daß der Ölfilm auf dem Abdeckband niemals zu dick und ungleichmäßig wird, bzw. daß sich auf dem Band 4 so viel Öl ansammelt, daß dieses vom Band abtropft oder bei der Berührung der beiden Bänder 3 und 4 auf die zu beschichtenden Partien des Folienbandes kriecht.

### Bezugszeichenliste

- 3: Isolierstoffband
- 4: Abdeckband
- 5: Bedampfungszone
- 6: Metallbedampfer
- 7: Heizer
- 8: Öl-Verdampfer
- 9: Aufwickelrolle
- 10: Vorratsrolle
- 11: Kragen
- 12: Verdampferkammer
- 13: Trennblech
- 14: Trennblech
- 15: Vakuumkammer
- 16: Beschichtungswalze
- 17: Wickelraum
- 18: Hilfswalze
- 19: Hilfswalze (Breitstreckwalze)
- 20: Verdampferkasten
- 21: Drahtzuführeinrichtung
- 22: Blende
- 23,23',...: Leitwalze
- 24: Metalldraht

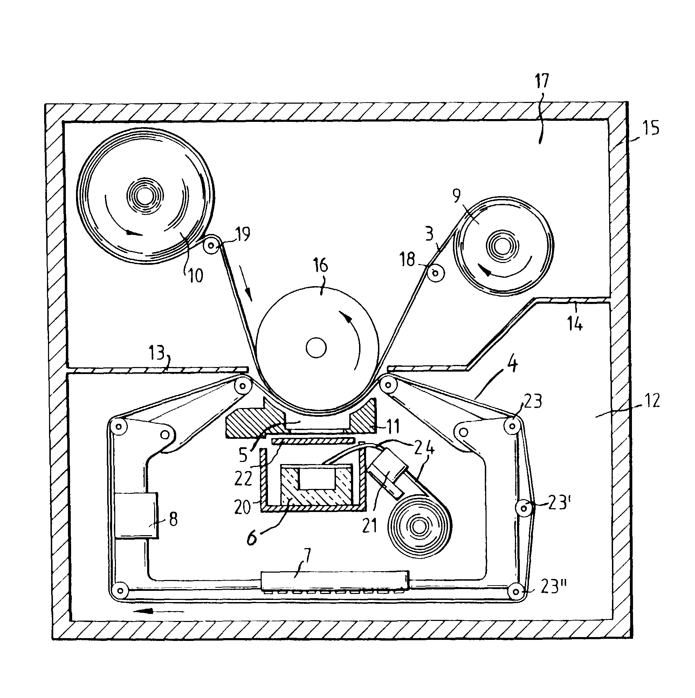

## Patentansprüche

1. Verfahren zur Herstellung von metallfreien Streifen bei der Metallbedampfung eines Isolierstoffbandes (3), das für den Einsatz in elektrischen Kondensatoren bestimmt ist, bei dem das Isolierstoffband (3) im Bereich der herzustellenden metallfreien Streifen durch ein endloses, am Isolierstoffband (3) anliegendes und mit gleicher Geschwindigkeit mit diesem mitlaufenden Abdeckband (4) abgedeckt wird, das vor dem Einlaufen in die Bedampfungszone (5) auf der dem Metallbedampfer (6) zugewandten Seite mit Öl beschichtet wird, wobei das Abdeckband (4) nach dem Durchlaufen durch die Bedampfungszone (5) und nach dem Auseinanderführen des Abdeckbandes (4) und des Isolierstoffbandes (3) vom aufgedampften Öl durch Erhitzen des Abdeckbandes (4) an einem in unmittelbarer Nachbarschaft des Abdeckbandes (4) angeordneten Heizer (7) befreit wird, wobei zuvor das Abdeckband (4) mit Hilfe des Verdampfers (8) mit Öl bedampft und danach mit dem zu metallisierenden Isolierstoffband (3) zusammengeführt wird und anschließend beide Bänder (3 und 4) gemeinsam durch die Bedampfungszone (5) geführt werden.

2. Vorrichtung zur Durchführung des Verfahrens nach Anspruch 1, die einen Metallverdampfer (6), einen Ölverdampfer (8), der in Laufrichtung des Abdeckbandes (4) vor dem Metallverdampfer angeordnet ist, Vorrats- bzw. Aufwikkelrollen (9,10) für das zu metallisierende Band (3) und eine Heizeinrichtung (7), die in Laufrichtung des Bandes (4) dem Metallverdampfer(6) nachgeschaltet ist, enthält, wobei die oberhalb des Metallverdampfers (6) angeordnete Bedampfungszone (5) mit Hilfe eines Kragens (11) von der Verdampferkammer (12) abgeschirmt ist und wobei Trennbleche (13,14) in der Vakuumkammer (15) angeordnet sind, die den Wickelraum (17) von der Verdampferkammer (12) abtrennen und sich bis an die Beschichtungswalze (16) erstecken.

## Claims

1. Method of producing metal-free strips during the metallization of an insulating tape (3) intended for use in electrical capacitors, whereby the insulating tape (3) in the region of the metal-free strips to be produced is covered by a continuous masking tape (4), which rests against and runs at the same speed as the insulating tape (3) and prior to entry into the metallizing zone (5) is coated with oil at the side directed towards the metallizer (6), wherein the vapour-deposited oil is removed from the masking tape (4) after passage through the metallizing zone (5) and after divergence of the masking tape (4) and the insulating tape (3) by heating the masking tape (4) at a heater (7) disposed in the immediate vicinity of the masking tape (4), the masking tape (4) previously being coated with oil with the aid of the vaporizer (8) and then being brought together with the insulating tape (3) to be metallized and then both tapes (3 and 4) being conveyed jointly through the metallizing zone (5).

2. Device for effecting the method according to claim 1, which comprises a metallizer (6), an oil vaporizer (8) disposed in running direction of the masking tape (4) upstream of the metallizer, supply and take-up rollers (9, 10) for the tape (3) to be metallized, and a heating device (7) disposed in running direction of the tape (4) downstream of the metallizer (6), wherein the metallizing zone (5) disposed above the metallizer (6) is screened off from the evaporation chamber (12) with the aid of a collar (11) and wherein there are disposed in the vacuum chamber (15) partition sheets (13, 14), which separate the winding area (17) from the evaporation chamber (12) and extend as far as the coating roller (16).

## Revendications

1. Procédé de fabrication de bandes exemptes de métal lors de la métallisation sous vide d'un ruban isolant (3) destiné à être utilisé dans des condensateurs électriques, dans lequel le ruban isolant (3) est recouvert, dans la région de la bande exempte de métal à fabriquer, par un ruban de recouvrement (4) sans fin, en contact sur le ruban isolant (3) et circulant avec celui-ci à la même vitesse, lequel est enduit d'huile sur la face orientée vers le dispositif de métallisation sous vide avant d'arriver dans la zone de métallisation (5), le ruban de recouvrement (4) étant libéré après la traversée de la zone de vaporisation (5) et après détachement du ruban de recouvrement (4) et du ruban isolant de l'huile vaporisée, en chauffant le ruban de recouvrement dans un dispositif de chauffage (7) agencé à proximité immédiate du ruban de recouvrement (4), ledit ruban de recouvrement (4) étant auparavant vaporisé d'huile à l'aide du vaporisateur (8) et ensuite réuni avec le ruban isolant (3) à métalliser et par la suite, les deux rubans (3 et 4) sont amenés conjointement à travers la zone de métallisation sous vide (5).

2. Dispositif permettant d'exécuter le procédé selon la revendication 1, comprenant un vaporisateur de métal (6), un vaporisateur d'huile (8) qui est agencé en amont du vaporisateur de métal en direction de circulation du ruban de recouvrement (4), des bobines de réserve et d'enroulement (9, 10) pour le ruban à métalliser et un dispositif de chauffage (7) monté en aval du vaporisateur de métal (6) en direction de circulation du ruban (4), la zone de métallisation (5) située au-dessus du vaporisateur de métal (6) étant abritée vis-à-vis de la chambre de vaporisation (12) par une collerette (11), et des tôles de séparation (13, 14) étant agencées dans la chambre à vide (15), lesquelles séparent la chambre d'enroulement (17) de la chambre de vaporisation (12) et s'étendent jusque contre le rouleau d'enduction (16).
